# EUROPEAN PATENT APPLICATION

(11) **EP 4 716 411 A1**
(43) Date of publication of application: **25.03.2026**
(21) Application number: 25199532.0
(22) Date of filing: 02.09.2025
(51) Int. Cl.: H10D 84/01, H10D 30/01, H10D 30/00, H10D 64/23, H10D 84/03, H10D 84/83, H10D 62/10, H10D 62/17

(54) **DEFECT-FREE EPITAXIAL SOURCE AND DRAIN STRUCTURES FOR RIBBON FIELD EFFECT TRANSISTORS**

(30) Priority: 23.09.2024 US 202418893800
(71) Applicant: INTEL Corporation, Santa Clara, CA 95054 (US)
(72) Inventor: CHU, Tao, Portland, 97229 (US); XU, Guowei, Portland, 97229 (US); CHAO, Robin, Portland, 97209 (US); ZHANG, Feng, Portland, 97229 (US); HUNG, Ting-Hsiang, Beaverton, 97007 (US); LIN, Chia-Ching, Portland, 97229 (US); ZHANG, Yang, Rio Rancho, 87124 (US); ZHANG, Kan, Hillsboro, 97123 (US); YEUNG, Chun Wing, Portland, 97229 (US); JANG, Minwoo, Portland, 97229 (US); LUO, Yanbin, Portland, 97229 (US); PACKAN, Paul, Hillsboro, 97124 (US); LIN, Chung-Hsun, Portland, 97229 (US); MURTHY, Anand, Portland, 97229 (US)
(74) Representative: 2SPL Patentanwälte PartG mbB

(57) **Abstract**

Devices, transistor structures, systems, and techniques are described herein related to gate all around field effect transistors having a stack of nanoribbons (i.e., semiconductor structures) contacted by epitaxial source and drain structures at opposite ends of the nanoribbons. The transistors include a gate structure vertically between the nanoribbons. The nanoribbons are doped at their opposing ends and/or gaps are laterally between the gate structure and the source and drain structures.

## Description

### BACKGROUND

Higher performance, lower cost, increased miniaturization, and greater density of integrated circuits (ICs) are ongoing goals of the electronics industry. To maintain the pace of increasing transistor performance, for example, multi-gate transistors such as gate-all-around (GAA) or nanoribbon transistors are being deployed. In such devices, the gate structure surrounds the channel region on all sides of each nanoribbon or ribbon of semiconductor material for improved drive current, device control, and other advantages. The nanoribbons or ribbons of semiconductor material are contacted on opposite sides by source and drain structures, which may be epitaxially grown materials. Currently, these transistors have difficulty with respect to growing defect free, high-quality epitaxial materials. For example, to prevent contact to gate (CTG) shorts and poor capacitive performance, inner spacers (laterally between the gate structure and the source and drain structures) can be used. However, having inner spacers during epitaxial growth breaks the super lattice during growth and causes crystal defects and misshapen structures, which in turn reduces transistor performance to due to lower material quality, relaxed strain, and other reasons.

It is with respect to these and other considerations that the present improvements have been needed. Such improvements may become critical as the desire to deploy multi-gate transistor structures such as ribbon field effect transistors becomes more widespread.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG.1 is a flow diagram illustrating exemplary methods for forming transistor structures with epitaxial source and drain structures coupled to a stack of semiconductor structures having doped ends and/or gaps between the ends of the semiconductor structures;
FIGS. 2, 3, 4, 5, 6, 7, 8, 9, 10, 11, 12, 13, 14, 15, and 16 are cross-sectional side views of example transistor structures as particular fabrication operations of the methods of FIG. 1 are performed;
FIG. 17 is a cross-sectional side view of a multi-layer integrated circuit device structure incorporating the transistor structure of FIG. 13;
FIG. 18 illustrates exemplary systems employing an integrated circuit assembly including an integrated circuit die having a transistor structure with a stack of semiconductor structures with doped ends and/or gaps between the ends of the semiconductor structures; and
FIG. 19 is a functional block diagram of an electronic computing device, all in accordance with at least some embodiments of the present disclosure.

### DETAILED DESCRIPTION

One or more embodiments or implementations are now described with reference to the enclosed figures. While specific configurations and arrangements are discussed, it should be understood that this is done for illustrative purposes only. Persons skilled in the relevant art will recognize that other configurations and arrangements may be employed without departing from the spirit and scope of the description. It will be apparent to those skilled in the relevant art that techniques and/or arrangements described herein may also be employed in a variety of other systems and applications other than what is described herein.

Reference is made in the following detailed description to the accompanying drawings, which form a part hereof, wherein like numerals may designate like parts throughout to indicate corresponding or analogous elements. It will be appreciated that for simplicity and/or clarity of illustration, elements illustrated in the figures have not necessarily been drawn to scale. For example, the dimensions of some of the elements may be exaggerated relative to other elements for clarity. Further, it is to be understood that other embodiments may be utilized, and structural and/or logical changes may be made without departing from the scope of claimed subject matter. It should also be noted that directions and references, for example, up, down, top, bottom, over, under, and so on, may be used to facilitate the discussion of the drawings and embodiments and are not intended to restrict the application of claimed subject matter. Therefore, the following detailed description is not to be taken in a limiting sense and the scope of claimed subject matter defined by the appended claims and their equivalents.

In the following description, numerous details are set forth. However, it will be apparent to one skilled in the art, that the present invention may be practiced without these specific details. In some instances, well-known methods and devices are shown in block diagram form, rather than in detail, to avoid obscuring the present invention. Reference throughout this specification to "an embodiment" or "one embodiment" means that a particular feature, structure, function, or characteristic described in connection with the embodiment is included in at least one embodiment of the invention. Thus, the appearances of the phrase "in an embodiment" or "in one embodiment" in various places throughout this specification are not necessarily referring to the same embodiment of the invention. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description of the invention and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items. Herein, the term "predominantly" indicates not less than 50% of a particular material or component while the term "substantially pure" indicates not less than 99% of the particular material or component and the term "pure" indicates not less than 99.9% of the particular material or component. Unless otherwise indicated, such material percentages are based on atomic percentage. Herein the term concentration is used interchangeably with material percentage and also indicates atomic percentage unless otherwise indicated.

The terms "coupled" and "connected," along with their derivatives, may be used herein to describe structural relationships between components. It should be understood that these terms are not intended as synonyms for each other. Rather, in particular embodiments, "connected" may be used to indicate that two or more elements are in direct physical or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause an effect relationship, an electrical relationship, a functional relationship, etc.).

The terms "over," "under," "between," "on", and/or the like, as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features. The term immediately adjacent indicates such features are in direct contact. Furthermore, the terms "substantially," "close," "approximately," "near," and "about," generally refer to being within +/- 10% of a target value. The term layer as used herein may include a single material or multiple materials. As used in throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C. The terms "lateral", "laterally adjacent" and similar terms indicate two or more components are aligned along a plane orthogonal to a vertical direction of an overall structure. As used herein, the terms "monolithic", "monolithically integrated", and similar terms indicate the components of the monolithic overall structure form an indivisible whole not reasonably capable of being separated.

Devices, transistor structures, integrated circuit dies, apparatuses, systems, and techniques are described herein related to gate-all-around field effect transistors (GAA-FETs) having nanoribbons with doped ends adjacent source and drain structures and/or gaps between the source and drain structures and a gate structure of the transistors.

As discussed, multi-gate transistors such as gate-all-around (GAA) or nanoribbon transistors are being deployed in advanced integrated circuit devices. As used herein, the terms nanowire, nanoribbon, stacked semiconductor structure, and similar terms are used substantially interchangeably to indicate a semiconductor material that extends from a source to a drain such that the semiconductor material is one of two or more such material structures that are separated and vertically aligned. The multiple semiconductor material structures each couple to the same source and drain, and are vertically separated by a gate structure, which may include a gate dielectric and a gate electrode. Thereby, the field effect transistor or device includes a source, a drain, and a stack of semiconductor structures extending between the source and the drain. The source and drain are epitaxial to the semiconductor structures. As used herein the term epitaxial to or similar terms indicate the materials are substantially lattice matched. The stack of semiconductor structures (e.g., two to about eight semiconductor structures) are controlled by the same gate electrode, and work in concert as the channel of the device. As used herein, the term channel region of a semiconductor structure indicates a region of a material layer adjacent to a gate dielectric and gate electrode that is to be controlled by the gate electrode to switch the transistor structure in operation. Notably, a region of a material layer need not be in operation to be characterized as a channel region, channel material, or the like. The term semiconductor structure is used broadly to include nanowires, nanoribbons, and similar terms.

Current GAA-FETs have difficulties including formation of defect free, high-quality epitaxial source and drain materials (e.g., source and drain epi). These difficulties translate to reduced transistor performance due to lower material quality and relaxed strain, for example. The difficulty in fabricating high-quality epitaxial source and drain materials is caused, in some contexts, by the presence of inner spacer materials during epitaxial growth. These dielectric spacer materials are vertically between the neighboring ones of the semiconductor structures of the stack and interface with the epitaxial growth, causing breaks in the super lattice of the epitaxial source and drain materials, defects, and other problems. As discussed further herein, growth of the epitaxial source and drain materials in the absence of the inner spacer materials improves source and drain material quality but the inner spacers are desirable for other aspects of device performance such as preventing contact to gate (CTG) shorts, poor capacitive performance, and others.

In some embodiments, epitaxial source and drain materials are grown without inner spacer materials. Instead, the epitaxial source and drain materials are grown from the semiconductor structures and interleaved sacrificial materials that provide a lattice match to the semiconductor structures and the epitaxial source and drain materials. For example, the semiconductor structures may be monocrystalline interleaved with sacrificial silicon-germanium sacrificial layers. After epitaxial source and drain material growth (or prior, in some embodiments), the ends of the silicon-germanium sacrificial layers are doped with a dopant species such as boron or gallium for PMOS (p-type metal-oxide-semiconductor) devices and phosphorous or arsenic for NMOS devices (n-type metal-oxide-semiconductor). The undoped portions of the silicon-germanium sacrificial layers may then be selectively removed (i.e., using wet etch) relative to the silicon semiconductor structures and the doped regions. This provides nanoribbon (i.e., semiconductor structure) release with a remaining material at and between the ends of the semiconductor structures. After gate formation, top side contact, and frontside processing, the doped silicon-germanium is accessed from the backside of the device and selectively removed. The remaining gaps may be pinched off by backside dielectric material. The remaining gaps provide insulation to reduce or eliminate the discussed CTG shorts and poor capacitive performance. Alternatively, after removal, the gaps may be filled with a dielectric material, which is buried by the discussed backside dielectric material. Backside processing may be completed to provide a high-performance GAA transistor that is contacted by both front and backside metallization. Advantageously, the discussed structures and techniques provide for epitaxial growth in the presence of sacrificial materials instead of dielectric spacer material for defect-free epitaxial growth while later fabricating gaps or dielectric spacer materials adjacent the gate electrodes for elimination of CTG shorts and improved capacitive performance.

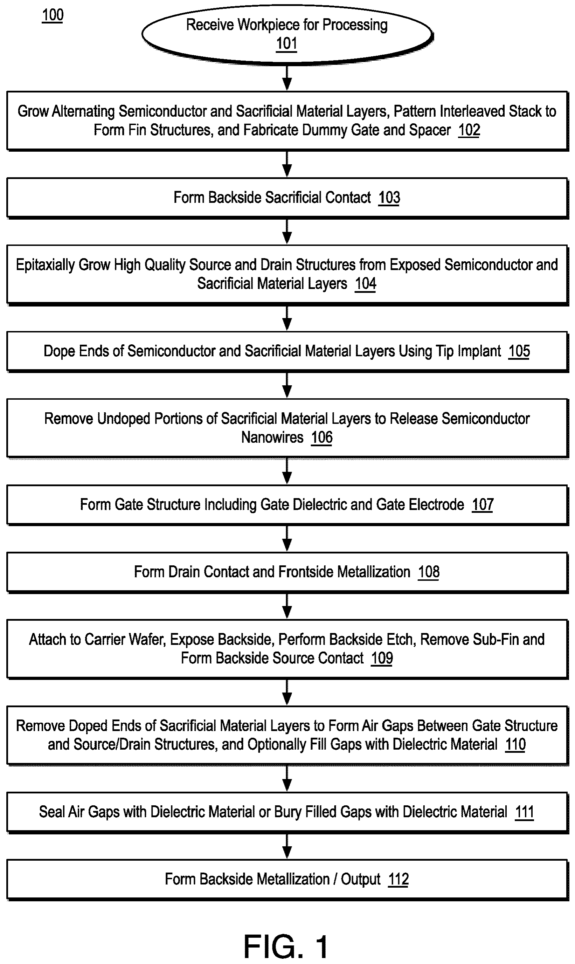

FIG.1 is a flow diagram illustrating exemplary methods 100 for forming transistor structures with epitaxial source and drain structures coupled to a stack of semiconductor structures having doped ends and/or gaps between the ends of the semiconductor structures, arranged in accordance with at least some implementations of the present disclosure. For example, methods 100 may be implemented to fabricate transistor structures 1300, 1600 or any other transistor structures discussed herein. In the illustrated implementation, methods 100 may include one or more operations as illustrated by operations 101-112. However, embodiments herein may include additional operations, certain operations being omitted, or operations being performed out of the order provided.

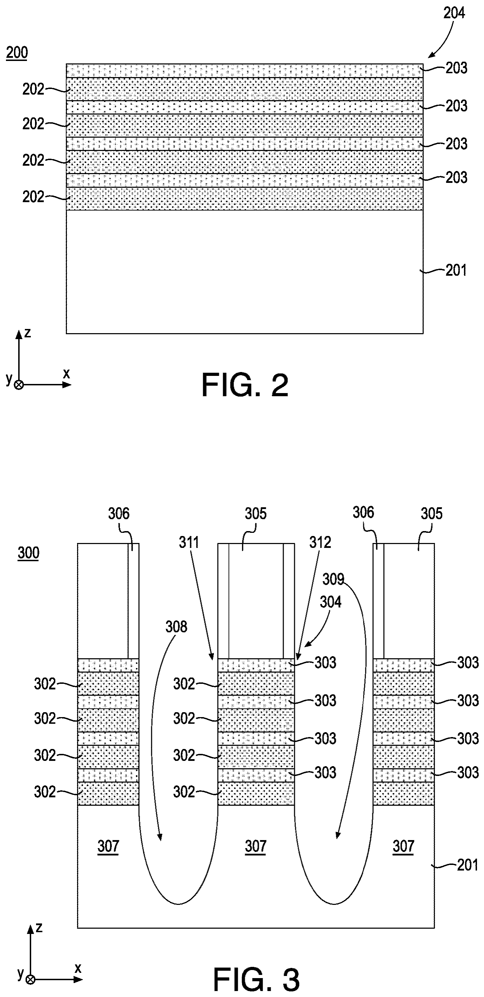

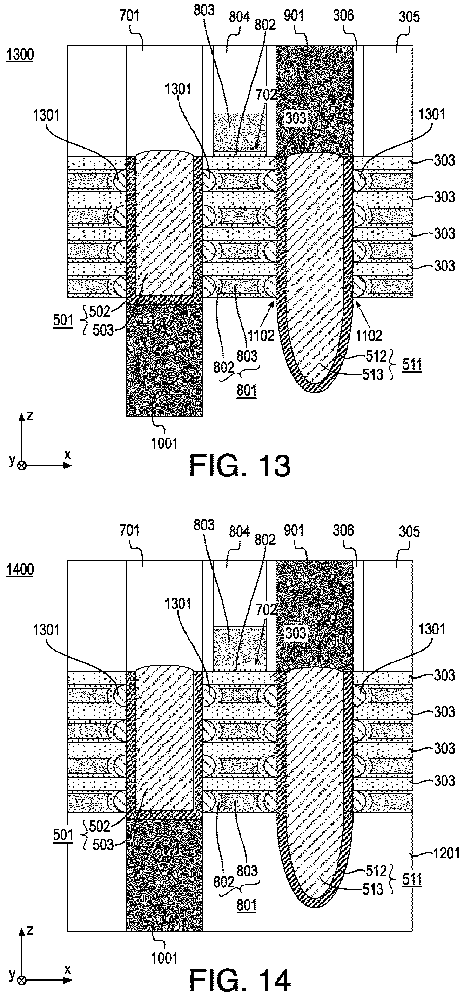

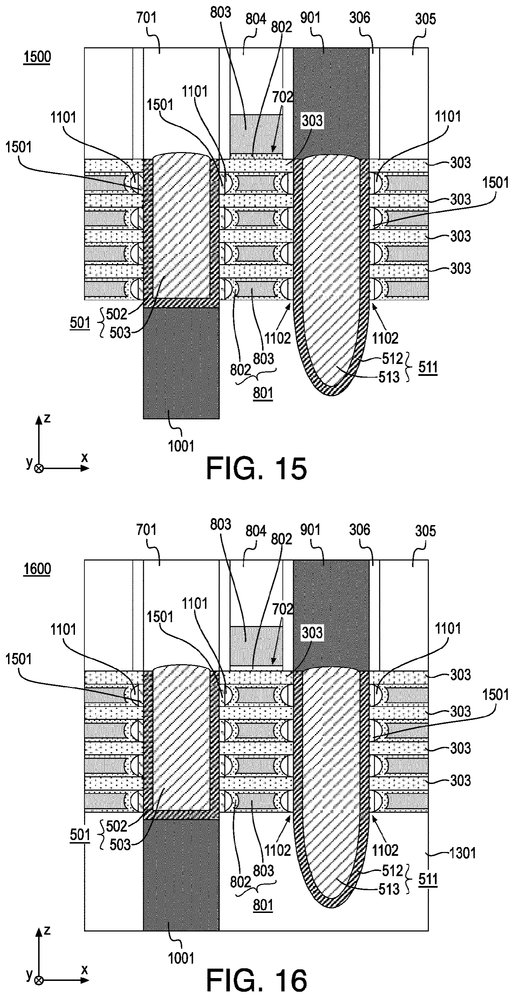

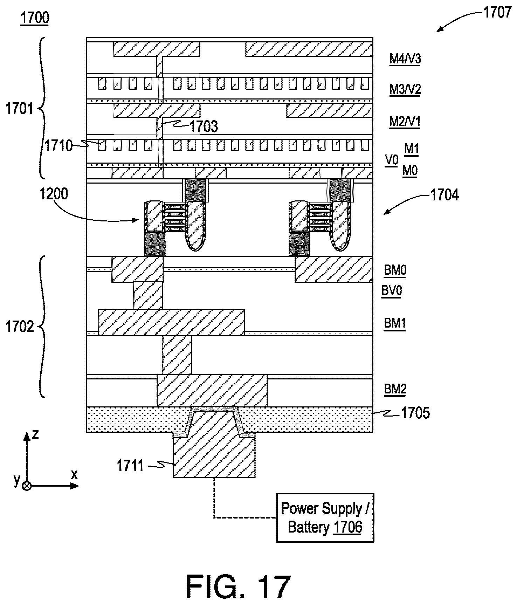

FIGS. 2, 3, 4, 5, 6, 7, 8, 9, 10, 11, 12, 13, 14, 15, and 16 are cross-sectional side views of example transistor structures as particular fabrication operations of methods 100 are performed, arranged in accordance with at least some implementations of the present disclosure. For example, methods 100 may be deployed to fabricate the transistor structures of FIG. 13, FIG. 16, or any other transistor structures discussed herein. FIG. 17 is a cross-sectional side view of the transistor structure of FIG. 13 incorporated in a multi-layer integrated circuit device structure. Although illustrated with respect to the transistor structure of FIG. 13, any transistor structure discussed herein may be deployed in the context of the multi-layer integrated circuit device structure of FIG. 17.

Processing begins at operation 101, where a workpiece such as a substrate is received for processing. The substrate may include any suitable substrate as discussed herein such as a silicon wafer or the like. In some embodiments, the substrate includes underlying devices or electrical interconnects. Processing continues at operation 102, where alternating layers of semiconductor material layers and sacrificial layers are formed over the workpiece or substrate, the alternating (or interleaved) layers of semiconductor material layers and sacrificial layers are patterned to form fin structures of the interleaved stack of semiconductor material layers and sacrificial layers, and dummy gate and spacer structures are formed.

The alternating layers of semiconductor material layers and sacrificial layers may be formed using any suitable technique or techniques such as epitaxial growth techniques, deposition techniques or the like. The semiconductor material layers and sacrificial layers may include any suitable materials and may have any thickness characteristics. The alternating layers of semiconductor material layers and sacrificial layers may be patterned into any number of fins using any suitable technique or techniques such as lithography and etch techniques. When patterned, the resultant semiconductor structures or nanoribbons are defined for use in a transistor structure. In some embodiments, the patterning includes one or more etches such to define the fin critical dimensions of the semiconductor material layers. Notably, the sacrificial layers are not recessed relative to the semiconductor material layers such that both may be used as an epitaxial growth surface in subsequent processing.

FIG. 2 is a cross-sectional side view of an example transistor structure 200. As shown, transistor structure 200 after growth of an interleaved stack 204 of alternating semiconductor material layers 203 and sacrificial material layers 202 over a substrate 201. Substrate 201 may include any suitable material or materials and, in some embodiments, substrate 201 includes a material or materials having the same or a similar composition with respect to semiconductor material layers 203. In some embodiments, substrate 201 and semiconductor material layers 203 include a Group IV material (e.g., silicon). In some embodiments, substrate 201 and semiconductor material layers 203 include a substantially monocrystalline material. In some embodiments, substrate 201 includes a buried insulator layer (e.g., SiO₂), for example, of a semiconductor-on-insulator (SOI) substrate and/or isolation insulator regions and the like.

Semiconductor material layers 203 may include any number of layers for the formation of semiconductor structures, channel semiconductors, nanoribbons, or nanowires over substrate 201 such as two, three, four, five, six, seven, eight or more layers with even numbers of semiconductor material layers 203 typically being deployed. Semiconductor material layers 203 are separated and interleaved with sacrificial material layers 202. Undoped portions of sacrificial material layers 202 will be removed and replaced by one or more gate structures inclusive of, for example, gate dielectric materials and gate electrode materials. Yet later in processing doped portions of sacrificial material layers 202 will be removed to provide gap structures.

Interleaved stack 204 of semiconductor material layers 203 and sacrificial material layers 202 may be formed using any suitable technique or techniques such as those discussed with respect to operation 102. Semiconductor material layers 203 and sacrificial material layers 202 are bulk layers that may be later patterned. In some embodiments, semiconductor material layers 203 are silicon such as monocrystalline silicon and sacrificial material layers 202 are silicon germanium, however other material systems may be used. Semiconductor material layers 203 and sacrificial material layers 202 may have any suitable thicknesses (i.e., measured in the z-dimension) such as thicknesses in the range of about 5 to 12 nm. In some embodiments, each of sacrificial material layers 202 have a greater thickness than any of semiconductor material layers 203. For example, sacrificial material layers 202 may each of a thickness of not less than 25% greater than that of any of semiconductor material layers 203.

FIG. 3 is a cross-sectional side view of an example transistor structure 300 similar to transistor structure 200, after the patterning of interleaved stack 204 to form patterned stacks 304, and formation of dummy gate structure 305 and spacer 306. In some embodiments, interleaved stack 204 are first etched to define fins extending in the x-dimension. Dummy gate structures 305, which extend in the y-dimension, may then be formed and patterned (i.e., by bulk deposition and patterning), and spacers 306 may then be formed. Subsequently, the fins may then be patterned under dummy gate structures 305 and spacers 306 to define patterned stacks 304 of sacrificial material layers 302 and semiconductor material layers 303. Notably, patterned stacks 304 may also be characterized as fins having a source to drain length is defined in the x-dimension. The source to drain length may be any suitable length such as a length in the range of 3 to 20 nm. For example, sacrificial material layers 302 and semiconductor material layers 203 may have length in the x-dimension of not less than 3 nm and not more than 20 nm. However, any source to drain lengths may be used. Also as shown, the patterning of interleaved stack 204 may form subfins 307 of substrate 201 due to openings 308, 309 extending into substrate 201. In some embodiments, opening 308 corresponds to a source opening 308 and opening 309 corresponds to a source opening 309. Dummy gate structures 305 and spacer 306 such as polysilicon and dielectric materials, respectively.

Notably, in the context of methods 100, sacrificial material layers 302 are not laterally recessed with respect to semiconductor material layers 303. For example, patterned stacks 304 include a first end 311 and a second end 312 such that second end 312 is laterally opposite first end 311. As used herein the term lateral indicates a direction or dimension in the x-y plane and the term vertical indicates a direction or dimension in the z-direction. Such terms comport with their use the art with the positive z-direction being a build-up direction and a frontside of the transistor structure and the negative z-direction being a backside of the transistor structure. By not recessing sacrificial material layers 302 and filling the recess with dielectric material, subsequent epitaxial materials may be grown from first ends 311 and second ends 312 of both semiconductor material layers 303 and sacrificial material layers 302 with significant lattice matching. Such growth conditions offer advantages with respect to the quality of the resulting epitaxial source and drain materials relative to growth in the presence of spacer materials in place of first ends 311 and second ends 312 sacrificial material layers 302.

Returning to FIG. 1, processing continues at operation 103, where a backside sacrificial contact is formed within an opening and below the exposed ends of the patterned interleaved semiconductor material layers and sacrificial material layers. The backside sacrificial contact may be formed using any suitable technique or techniques such as patterning and etch to expand the contact opening, bulk deposition, and recessing techniques.

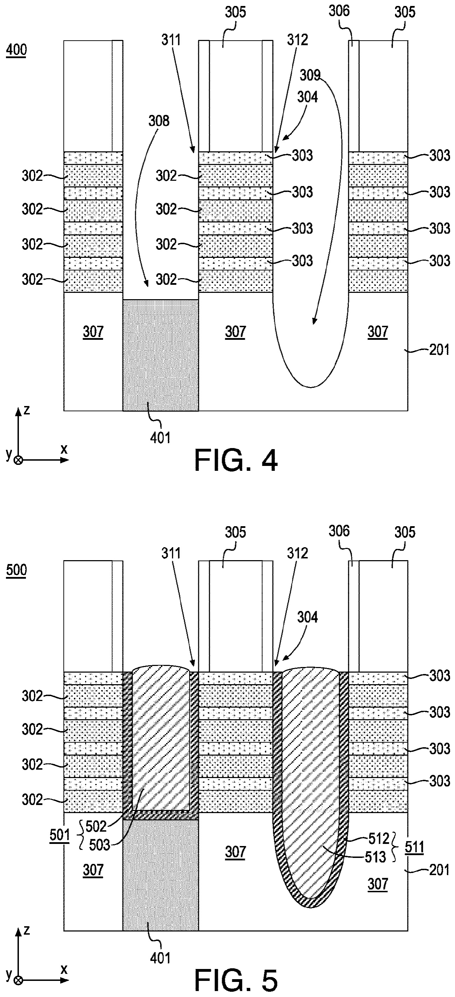

FIG. 4 is a cross-sectional side view of an example transistor structure 400 similar to transistor structure 300, after formation of a recessed sacrificial or placeholder contact structure 401 within opening 308. Sacrificial or placeholder contact structure 401 may be fabricated using any suitable technique or techniques such as patterning and etch, deposition, and recess etch techniques. Sacrificial or placeholder contact structure 401 may be any suitable material that may be reliably and accurately formed and recessed within opening 308, and that characteristics, such as etch selectivity for later fabrication of a backside contact. In some embodiments, sacrificial or placeholder contact structure 401 is titanium nitride (e.g., sacrificial or placeholder contact structure 401 may include titanium and nitride). It is noted that sacrificial or placeholder contact structure 401 may extend partially into substrate 201, and sacrificial or placeholder contact structure 401 may later be revealed by backside removal processes such as etching or grinding techniques.

Returning to FIG. 1, processing continues at operation 104, where epitaxial source and drain materials are epitaxially grown or deposited via the exposed ends of the stacks of interleaved semiconductor material layers and sacrificial material layers. In some embodiments, an epitaxial nucleation layer may be deposited, followed by bulk deposition. In some embodiments, the epitaxial nucleation layer and bulk epitaxial materials are deposited in the same process chamber using differing deposition parameters. The source and drain materials may be any suitable materials such as doped silicon, doped silicon germanium, or the like. The epitaxial source and drain materials may be deposited using any suitable technique or techniques such as chemical vapor deposition (CVD) including dopant materials.

FIG. 5 is a cross-sectional side view of an example transistor structure 500 similar to transistor structure 400, after the epitaxial growth of source structure 501 and drain structure 511. As shown, in some embodiments, source structure 501 includes an epitaxial nucleation layer 502 and a bulk epitaxial material 503. Similarly, drain structure 511 may include an epitaxial nucleation layer 512 and a bulk epitaxial material 513. In some embodiments, epitaxial nucleation layers 502, 512 have a lower dopant concentration than bulk epitaxial materials 503, 513. In some embodiments, the dopant concentration of epitaxial nucleation layers 502, 512 is not more than 25% of a dopant concentration of bulk epitaxial materials 503, 513.

Source structure 501 and drain structure 511 may be fabricated using CVD or other epitaxial deposition techniques. As discussed, source structure 501 and drain structure 511 are epitaxial to exposed ends 311, 312 of patterned stacks 304 including ends 311, 312 of each of sacrificial material layers 302 and semiconductor material layers 303. Notably, due to the presence of ends 311, 312 of each of sacrificial material layers 302 (instead of a spacer material), a high-quality epitaxial material is present in source structure 501 and drain structure 511. In some embodiments, each of source structure 501 and drain structure 511 have an extremely low defect presence. For example, to detect defects, an image such as a TEM (transmission electron microscopy) image may be taken of the source structure 501 or drain structure 511 and instances of defects such as dislocation defects, linear, defects, planar defects, or the like may be automatically or manually counted. In some embodiments, the defect count in each of source structure 501 and drain structure 511 is not more than 5 defects. In some embodiments, the defect count in each of source structure 501 and drain structure 511 is not more than 2 defects. In some embodiments, the defect count in each of source structure 501 and drain structure 511 is not more than 1 defects. This may be contrasted with defects of not fewer than 10 defects when epitaxial materials are grown in the presence of a spacer dielectric in place of ends 311, 312 of each of sacrificial material layers 302.

As discussed, source structure 501 and drain structure 511 may be epitaxial bodies such as doped epitaxial silicon or doped epitaxial silicon and germanium (SiGe), for example source structure 501 and drain structure 511 may each include silicon and a dopant or silicon, germanium, and a dopant. In some embodiments, the dopant is boron or gallium for PMOS devices and phosphorous or arsenic for NMOS devices, although other suitable dopants may be used. The formation of source structure 501 and drain structure 511 provide interfaces between semiconductor material layers 303 and each of source structure 501 and drain structure 511 as well as interfaces between sacrificial material layers 302 and each of source structure 501 and drain structure 511.

Returning to FIG. 1, processing continues at operation 105, where the ends of the interleaved semiconductor material layers and sacrificial material layers are doped using tip implant. In some embodiments, the tip implant is an angled implant. Notably, the implant provides doped ends of the semiconductor material layers and sacrificial material layers and, laterally between the doped ends, a low or undoped region of the semiconductor material layers and sacrificial material layers. In the sacrificial material layers a material difference is thereby established that can be exploited to provide etch selectivity between the doped ends and the undoped region. During subsequent nanowire release (i.e., exposure of the semiconductor material layers), the undoped region can be etched out while the doped ends remain. The implant may include any suitable process parameters and the dopant species may be any suitable element. In some embodiments, the dopant species is boron or gallium for PMOS devices and phosphorous or arsenic for NMOS devices. However, boron, gallium, phosphorous, and arsenic may be used in any combination for any device type, and other dopant species may be deployed. It is noted that in methods 100, the tip implant of operation 105 is performed after the epitaxial growth of operation 104. In some embodiments, the tip implant of operation 105 may be performed prior to epitaxial growth.

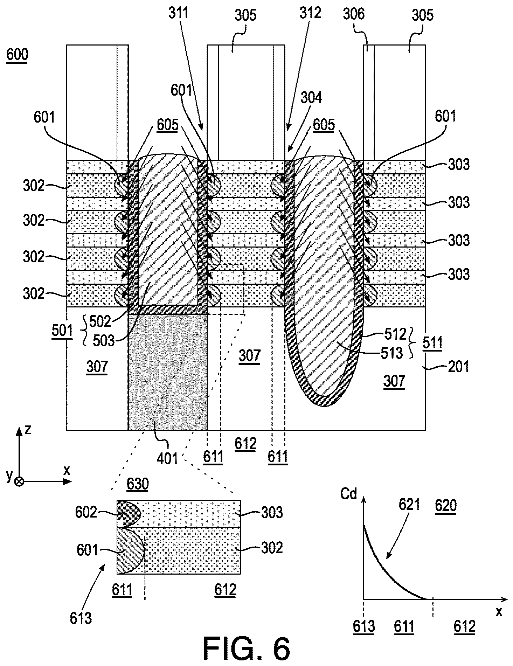

FIG. 6 is a cross-sectional side view of an example transistor structure 600 similar to transistor structure 500, during and after doping or implant 605. As shown, implant 605 may be an angled implant into the tips or ends 311, 312 of sacrificial material layers 302 and semiconductor material layers 303. In the upper portion of FIG. 6, implant 605 is shown as doping a semicircular (in cross-section) portion, region, or end 601 of sacrificial material layers 302 while semiconductor material layers 303 are illustrated as unaltered. This illustration carries forward in subsequent FIGS. and is used for the sake of clarity of presentation of the disclosed embodiments. However, as shown in insert 630, ends 311, 312 of both sacrificial material layers 302 and semiconductor material layers 303 are doped by implant 605. Although illustrated with semicircular (in cross-section) doped portions, regions, or ends 601 of sacrificial material layers 302 and doped portions, regions, or ends 602 of semiconductor material layers 303, doped ends 601 of sacrificial material layers 302 and doped ends 602 of semiconductor material layers 303 may have any suitable dopant profile or shape.

Implant 605 thereby provides for doped (or highly doped) end regions 611 of sacrificial material layers 302 and semiconductor material layers 303, and an undoped (or lowly doped) central region 612 of sacrificial material layers 302 and semiconductor material layers 303. Notably, although labeled as undoped central region 612 for the sake of clarity, central region 612 may include dopant species due to implant 605 and/or diffusion due to thermal processing. Doped end regions 611 and undoped central region 612 may have any dopant concentrations (in both sacrificial material layers 302 and semiconductor material layers 303) that provide etch selectivity therebetween, which is pertinent to later processing of sacrificial material layers 302. The dopant concentration in doped end regions 611 may be taken at any position in end region 611 and the dopant concentration at central region 612 may be taken at a lateral midpoint of sacrificial material layers 302 and semiconductor material layers 303. In some embodiments, doped end regions 611 are doped with a dopant species at not less than a first dopant concentration and undoped central region 612 of each of the semiconductor structures has a second dopant concentration of the dopant species of not more than 10% of the first dopant concentration. In some embodiments, the first dopant concentration is not more than 5% of the first dopant concentration. In some embodiments, the first dopant concentration is not more than 2% of the first dopant concentration. In some embodiments, the first dopant concentration is not more than 1% of the first dopant concentration. In some embodiments, the dopant species is present in doped end regions 611 and is not present in undoped central region 612.

Also as shown with respect to exemplary graph 620, implant 605 may provide a dopant profile having a dopant concentration gradient 621 that decreases monotonically from an edge 613 of sacrificial material layers 302 and semiconductor material layers 303 toward central region 612 of sacrificial material layers 302 and semiconductor material layers 303. For example, dopant concentration gradient 621 may be a measure of dopant concentration (Cd) over lateral distance (x) with lateral distance (x) originating at edge 613 and extending toward central region 612. As shown, dopant concentration gradient 621 may reduce monotonically across doped end regions 611 toward central region 612 such that the presence of dopant species is no longer detected in central region 612, in some embodiments. Although illustrated with respect to a convex function, dopant concentration gradient 621 may have any shape such as a linear decrease.

Returning to FIG. 1, processing continues at operation 106, where the undoped portions of the interleaved sacrificial material layers are removed using selective etch techniques such as wet etch techniques. Notably, after selective removal, the doped end regions of the sacrificial material layers as well as the semiconductor material layers remain. As discussed, the lack of dopant in the undoped central regions of the sacrificial material layers provides etch selectivity relative to the presence of the dopant in the doped end regions. Furthermore, etch selectivity is provided between the sacrificial material layers and the semiconductor material layers due to the differing materials deployed (e.g., silicon germanium sacrificial material layers and substantially pure or pure silicon semiconductor material layers). The removal of the undoped portions of the interleaved sacrificial material layers provides for nanowire release or exposure of the semiconductor material layers. Prior to the removal of the undoped portions of the interleaved sacrificial material layers, a dielectric fill may be provided over the exposed source and drain structures. It is noted the undoped portions of the interleaved sacrificial material layers may be accessed by patterning holes in the overlying dielectric materials.

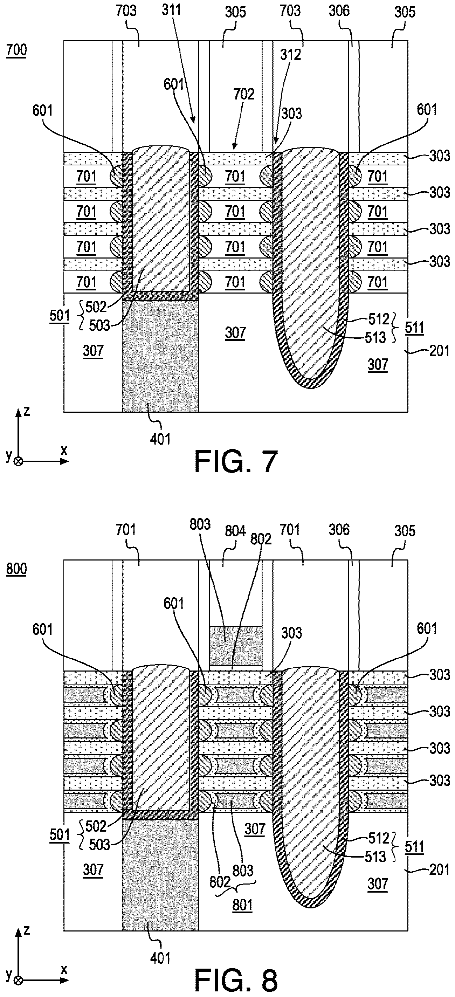

FIG. 7 is a cross-sectional side view of an example transistor structure 700 similar to transistor structure 600, after formation of dielectric fill material 703, which may be any suitable material such as a silicon oxide, silicon nitride, silicon oxynitride, or the like, and after removal of undoped portions of sacrificial material layers 302 to release or expose semiconductor material layers 303 and to form openings 701. As discussed, undoped portions of sacrificial material layers 302 may be removed using any suitable technique or techniques such as selective wet etch techniques. Notably, doped ends 601 of sacrificial material layers 302 remain after such processing. Doped ends 601 of sacrificial material layers 302 provide a placeholder for a later formed gap or a dielectric material.

As shown, removal of undoped portions of sacrificial material layers 302 releases semiconductor material layers 303 to provide a stack of semiconductor structures 702 with the stack including vertically aligned semiconductor material layers 303, which may be characterized as semiconductor structures, nanowires, nanoribbons, channel semiconductors, or the like. Each semiconductor structure of stack of semiconductor structures 702 is coupled with and epitaxial to source structure 501 and drain structure 511 at opposite lateral ends 311, 312 of stack of semiconductor structures 702. It is noted stack of semiconductor structures 702 retain their doping profiles as discussed herein with respect to FIG. 6.

Returning to FIG. 1, processing continues at operation 107, where the sacrificial materials removed at operation 106 are replaced by a gate structure, which may include a gate dielectric material on at least portions of the semiconductor structures and the doped end regions of the sacrificial material layers, and a gate electrode (e.g., gate metal) on the gate dielectric material. The gate structure may be formed using any suitable technique or techniques. In some embodiments, the gate dielectric material is be formed using conformal deposition processing, and the gate electrode is formed by conformal deposition (of a work function metal) followed by metal fill. However, other fabrication techniques may be used.

FIG. 8 is a cross-sectional side view of an example transistor structure 800 similar to transistor structure 700, after formation of gate structure 801, which includes gate dielectric layer 802 and a gate electrode 803. Fabrication of gate structure 801 may also include the formation of isolation material 804, which may include any suitable dielectric material such as silicon oxide, silicon nitride, silicon oxynitride, or the like. As discussed, gate structure 801 may be formed by conformal deposition of gate dielectric layer 802 followed by conformal deposition of a work function metal of gate electrode 803 followed by metal fill of a remainder of gate electrode 803.

In some embodiments, gate dielectric layer 802 of gate structure 801 includes a layer that is or includes aluminum oxide, hafnium oxide, zirconium oxide, titanium silicon oxide, hafnium silicon oxide, or silicon nitride. For example, gate dielectric layer 802 may include aluminum and oxygen; hafnium and oxygen; zirconium and oxygen; titanium, silicon, and oxygen; hafnium, silicon, and oxygen; or silicon and nitrogen. In some embodiments, gate electrode 803 of gate structure 801 includes a work function layer of platinum, nickel, titanium nitride, or tantalum nitride and a fill metal such as tungsten. However, other material systems may be used.

Returning to FIG. 1, processing continues at operation 108, where any of the source structure, drain structure, and gate structure are contacted by frontside metal contacts using any suitable technique or techniques such as patterning and metal deposition processing as is known in the art. For example, frontside contacts may be made to any one or more of the source, drain, and gate of the transistor structure being fabricated. For example, the transistor structure is a three terminal device to be contacted at the source, drain, and gate, and any of these may be contacted from the frontside or backside of the device structure. The frontside contacts are then interconnected by metallization layers over the frontside contact. In some embodiments, the gate and drain of the transistor structure are contacted from the frontside to provide signal routing and the source of the transistor structure is contacted from the backside to provide power delivery. However, any interconnect routing may be used.

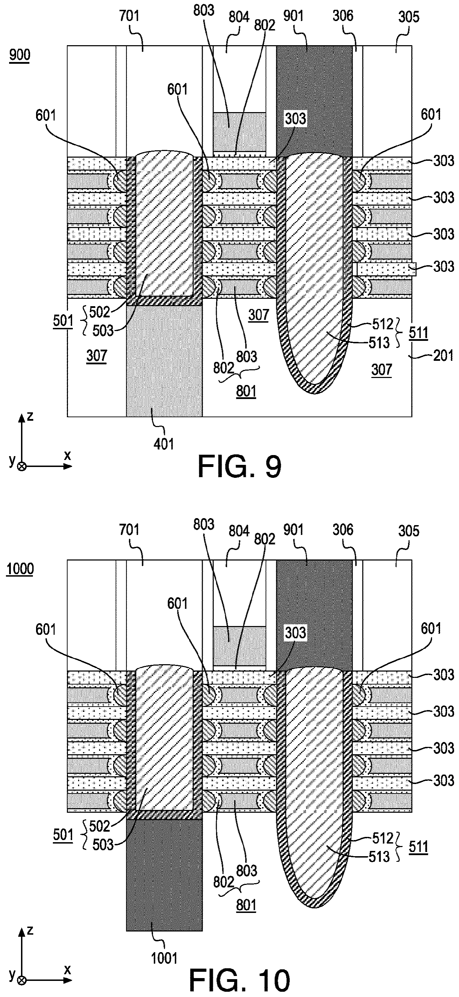

FIG. 9 is a cross-sectional side view of an example transistor structure 900 similar to transistor structure 800, after the formation of frontside drain contact 901 in contact with drain structure 511 and/or a frontside gate contact (not shown) in contact with gate electrode 803. For example, the gate contact may be into or out of the page of the illustrated cross section. Frontside drain contact 901 and the frontside gate contact may be formed using operations known in the art such as lithography patterning of vias and via fill and optional planarization to form frontside drain contact 901 and the frontside gate contact. Such components may include any suitable materials. For example, frontside drain contact 901 and the frontside gate contact may include a liner material such as titanium nitride and a fill metal such as tungsten. However, other material systems may be used. Over transistor structure 900, frontside metallization layers may be formed using any suitable technique or techniques such as dual damascene techniques, single damascene techniques, subtractive metallization patterning techniques, or the like. Frontside metallization layers are illustrated herein below with respect to FIG. 17. Notably, frontside metallization layers may be formed prior to mounting transistor structure 900 to a carrier wafer and performing backside processing as discussed below.

Returning to FIG. 1, processing continues at operation 109, where the partially fabricated workpiece is mounted, by its frontside, to a carrier such as a carrier wafer, and the backside of the transistor structure is exposed through the backside of the substrate of the workpiece. After backside exposure, subfins are removed and the backside sacrificial contact formed at operation 103 is replaced with a backside contact. The workpiece may be mounted to the carrier using any suitable technique or techniques such as application of an adhesive film between the workpiece and carrier. The transistor structure backside is then exposed using any suitable technique or techniques such as backside substrate removal processing including backside grind, backside etch or the like to thin the substrate wafer.

The backside sacrificial contact formed at operation 103 is replaced with a backside contact is then replaced with a backside metal contact using any suitable technique or techniques such as etch, metal deposition processing, and planarization processing as is known in the art. As discussed, frontside contacts may contact the drain and the gate of the transistor structure and the backside contact may contact the source of the transistor structure. However, contact architecture may be used.

FIG. 10 is a cross-sectional side view of an example transistor structure 1000 similar to transistor structure 900, after attachment to a carrier (not shown) over a top surface (i.e., in the z-direction) of transistor structure 1000, replacement of sacrificial or placeholder contact structure 401 with backside source contact 1001, and removal of substrate 201 including subfins 307. Backside source contact 1001 may be formed using operations known in the art such as etch removal of sacrificial or placeholder contact structure 401, via fill, and optional planarization to form backside source contact 1001. Backside source contact 1001 may include any suitable materials such as a liner material such as titanium nitride and a fill metal such as tungsten. Other material systems may be used. As shown, substrate 201, including subfins 307, may be removed using any suitable technique or techniques.

Returning to FIG. 1, processing continues at operation 110, where the doped ends of the sacrificial material layers are accessed from the backside and removed to form gaps of air or other gas vertically between the ends of the semiconductor material layers and laterally between the gate structure and the source structure or the drain structure. As also shown at operation, the gap may then be filled, partially or fully, with a dielectric material in some embodiments. The doped ends of the sacrificial material layers may be removed using any suitable technique or techniques such as selective wet etch techniques. The removal of the doped ends of the sacrificial material layers provides for a spacer of insulative material (i.e., either air or dielectric fill). As discussed, the techniques of methods 100 allow for high-quality source and drain epitaxial contact fabrication (by growing the epi absent spacer insulator) while still providing the advantages of the insulative spacer by backside removal of the doped ends of the sacrificial material layers.

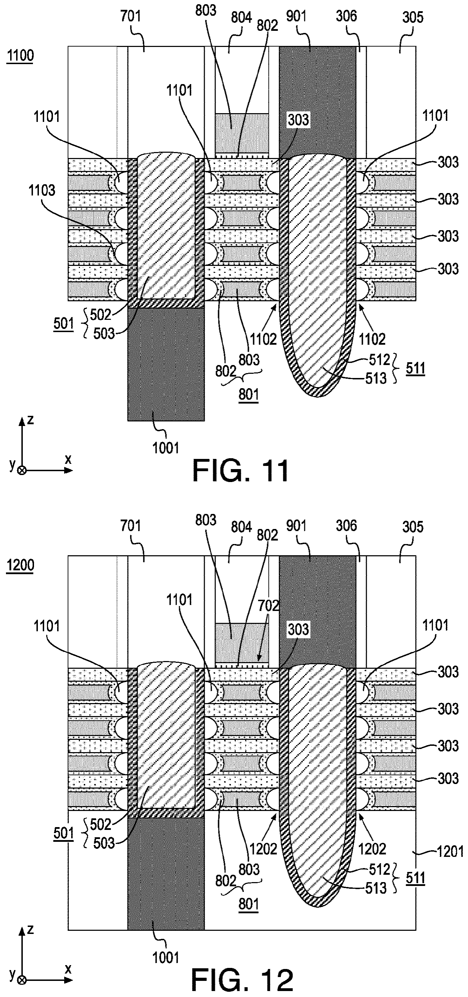

FIG. 11 is a cross-sectional side view of an example transistor structure 1100 similar to transistor structure 1000, after removal of doped ends 601 of sacrificial material layers 302. As discussed, doped ends 601 of sacrificial material layers 302 may be removed using etch techniques such as selective wet etch techniques. In some embodiments, doped ends 601 of sacrificial material layers 302 are accessed via openings 1102 that are opened using the discussed backside substrate removal processing. Removal of doped ends 601 of sacrificial material layers 302 forms gaps 1101. Gaps 1101 may also be characterized as voids or cavities. In some embodiments, gaps 1101 are filled with air or another gas. As shown, in some embodiments, gate structures 801 include concave regions 1103 due to being formed on doped ends 601 of sacrificial material layers 302. However, other profiles may be present.

Returning to FIG. 1, processing continues at operation 111, where the gaps formed at operation 110 are sealed or the filled gaps are buried with backside dielectric material. The backside dielectric material layer may be formed using any suitable technique or techniques. In some embodiments, a bulk material such as silicon oxide is formed over the device backside and subsequently planarized. The backside dielectric material may pinch off and seal the gaps filled with air or other gas, pinch off and seal gaps partially filled with dielectric with the remainder filled with air or other gas, or bury gaps fully or partially filled with dielectric material. Embodiments where gaps filled with air or other gas are sealed are shown with respect to FIG. 12. Embodiments with partially filled gaps are shown with respect to FIGS. 13 and 14 and

FIG. 12 is a cross-sectional side view of an example transistor structure 1200 similar to transistor structure 1100, after formation of backside dielectric layer 1201. Backside dielectric layer 1201 may include any insulative material such as silicon oxide and backside dielectric layer 1201 may be formed using any suitable technique or techniques such as bulk deposition followed by planarization processing to reveal backside source contact 1001.

As shown, backside dielectric layer 1201 seals openings 1102 to provide a seal 1202 of voids, cavities, or gaps 1101. In some embodiments, backside dielectric layer 1201 seals openings 1102 air or another gas within gaps 1101. In some embodiments, gaps 1101 are characterized as air gaps. Transistor structure 1200 includes stack of semiconductor structures 702 such that semiconductor material layers 303 (e.g., semiconductor structures) are vertically aligned. Transistor structure 1200 further includes source structure 501 and drain structure 511 epitaxial to opposing ends of each of semiconductor material layers 303, and gate structure 801 vertically between each of the semiconductor structures. In some embodiments, transistor structure 1200 further includes one or more gaps 1101 filled with air or other gas such that gaps 1101 are laterally between gate structure 801 and source structure 501 and drain structure 511. In some embodiments, as discussed with respect to FIG. 6, the ends of each of the semiconductor structures are doped with a dopant species at not less than a first dopant concentration and a center region of each of the semiconductor structures has a second dopant concentration less than the first dopant concentration.

As discussed, in some embodiments gaps 1101 may be fully or partially filled with a dielectric material.

FIG. 13 is a cross-sectional side view of an example transistor structure 1300 similar to transistor structure 1100, after filling dielectric spacer material into gaps 1101 to form dielectric spacers 1301. Dielectric spacers 1301 may include any suitable insulative material such as silicon oxide, silicon nitride, silicon oxynitride, or the like. For example, dielectric spacers 1301 may include silicon and oxygen; silicon and nitrogen; or silicon, oxygen, and nitrogen oxynitride. Other insulative materials may be used. In some embodiments, as shown in FIG. 13, the dielectric spacer material of dielectric spacers 1301 fully fills gaps 1101.

FIG. 14 is a cross-sectional side view of an example transistor structure 1400 similar to transistor structure 1300, after formation of backside dielectric layer 1201. As shown, backside dielectric layer 1201 buries dielectric spacers 1301. Transistor structure 1400 includes stack of semiconductor structures 702, source structure 501 and drain structure 511 epitaxial to opposing ends of each of semiconductor material layers 303, and gate structure 801 vertically between each of the semiconductor structures. In some embodiments, transistor structure 1400 further includes one or more dielectric spacers 1301 laterally between gate structure 801 and source structure 501 and drain structure 511, and vertically between ends of semiconductor material layers 303. In some embodiments, as discussed with respect to FIG. 6, the ends of each of the semiconductor structures are doped with a dopant species at not less than a first dopant concentration and a center region of each of the semiconductor structures has a second dopant concentration less than the first dopant concentration.

FIG. 15 is a cross-sectional side view of an example transistor structure 1500 similar to transistor structure 1100, after partially filling dielectric spacer material into gaps 1101 to form partial dielectric spacers 1501. Partial dielectric spacers 1501 may include any suitable insulative material such as silicon oxide, silicon nitride, silicon oxynitride, or the like. For example, partial dielectric spacers 1501 may include silicon and oxygen; silicon and nitrogen; or silicon, oxygen, and nitrogen oxynitride. In some embodiments, as shown in FIG. 15, partial dielectric spacers 1501 partially fill gaps 1101 such that gaps 1101 are still present. In some embodiments, gaps 1101 are between partial dielectric spacers 1501 and one of gate structures 801 (as shown) or source/drain structures 501, 511, or both. In some embodiments, gaps 1101 are filled with air or other gas.

FIG. 16 is a cross-sectional side view of an example transistor structure 1600 similar to transistor structure 1500, after formation of backside dielectric layer 1201. As shown, backside dielectric layer 1201 seals air gaps 1101 and buries partial dielectric spacers 1501. Transistor structure 1600 includes stack of semiconductor structures 702, source structure 501 and drain structure 511 epitaxial to opposing ends of each of semiconductor material layers 303, and gate structure 801 vertically between each of the semiconductor structures. In some embodiments, transistor structure 1600 further includes filled with air or other gas and partial dielectric spacers 1501 both laterally between gate structure 801 and source structure 501 and drain structure 511, and vertically between ends of semiconductor material layers 303. In some embodiments, as discussed with respect to FIG. 6, the ends of each of the semiconductor structures are doped with a dopant species at not less than a first dopant concentration and a center region of each of the semiconductor structures has a second dopant concentration less than the first dopant concentration.

Returning to FIG. 1, processing continues at operation 112, where backside metallization is formed over the source contact, additional fabrication processes may be completed, and the resultant structure may be output. Such processing may include backend processing, dicing, packaging, assembly, and so on. The resultant device (e.g., integrated circuit die) may then be implemented in any suitable form factor device such as a laptop, a netbook, a notebook, an ultrabook, a smartphone, a tablet, a personal digital assistant, an ultra-mobile PC, a mobile phone, a desktop computer, a server, a printer, a scanner, a monitor, a set-top box, an entertainment control unit, a digital camera, a portable music player, a digital video recorder, or the like.

FIG. 17 is a cross-sectional side view of a multi-layer integrated circuit device structure 1700 incorporating transistor structure 1200, in accordance with at least some embodiments of the present disclosure. Although illustrated and discussed with respect to transistor structure 1200 of FIG. 12, any transistor structure discussed herein such as transistor structure 1400 of FIG. 14 or transistor structure 1600 of FIG. 16 may be deployed in the context of multi-layer integrated circuit device structure 1700. As shown, multi-layer integrated circuit device structure 1700 is incorporated in integrated circuit (IC) die 1707 such that multi-layer integrated circuit device structure 1700 includes frontside metallization layers 1701 (or frontside interconnect layers) and backside metallization layers 1702 (or backside interconnect layers). Frontside metallization layers 1701 and backside metallization layers 1702 may be formed using any suitable technique or techniques such as dual damascene techniques, single damascene techniques, subtractive metallization patterning techniques, or the like. In some embodiments, frontside metallization layers 1701 are fabricated over frontside drain contact 901 as discussed with respect to FIG. 9. In some embodiments, backside metallization layers 1702 may be fabricated over backside source contact 1001.

For example, interconnectivity, signal routing, power-delivery, and the like may be provided by frontside metallization layers 1701. Adjacent metallization layers, such as metallization interconnects 1710, are interconnected by vias, such as vias 1703, that may be characterized as part of the metallization layers or between the metallization layers. As shown, in some embodiments, frontside metallization layers 1701 are formed over and immediately adjacent transistor structure 1300. In the illustrated example, frontside metallization layers 1701 include M0, V0, M1, M2/V1, M3/V2, and M4/V3. However, frontside metallization layers 1701 may include any number of metallization layers such as six, eight, or more metallization layers.

Similarly, backside metallization layers 1702, may be used for interconnectivity, signal routing, power-delivery, and any other suitable electrical connectivity. In some embodiments, frontside metallization layers 1701 are used exclusively for signal routing and backside metallization layers 1702 are used exclusively for power delivery. However, any interconnection architecture may be used. In the illustrated example, package level interconnects 1711 are provided on or over a device backside as bumps over a passivation layer 1705. However, package level interconnects 1711 may be provided using any suitable interconnect structures such as bond pads, solder bumps, etc. As shown, in some embodiments, backside metallization layers 1702 are formed over and immediately adjacent transistor structure 1200 such that a device layer 1704 including transistor structure 1200 is between frontside metallization layers 1701 and backside metallization layers 1702. In the illustrated example, backside metallization layers 1702 include BM0, BM1, and BM2 with intervening via layers. However, backside metallization layers 1702 may include any number of metallization layers such as three, four, or more metallization layers.

In some embodiments, one of transistor structures 1200, 1400, 1600 is deployed in a monolithic integrated circuit (IC) die 1707 including a gate-all-around field effect transistor structure (e.g., a GAA-FET), the GAA-FET transistor structure including any of the discussed components and characteristics. As shown, a power supply 1706 may be coupled to IC die 1707, such that power supply 1706 may include a battery, voltage converter, power supply circuitry, or the like.

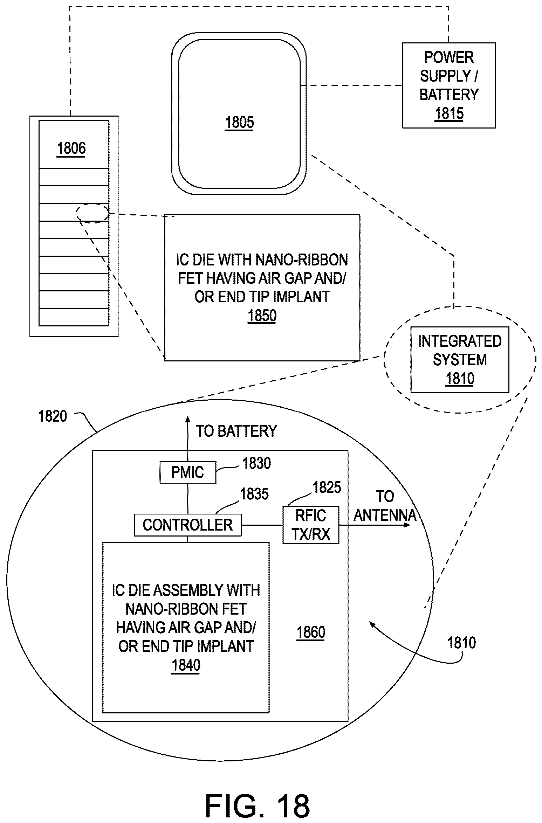

FIG. 18 illustrates exemplary systems employing an integrated circuit assembly including an integrated circuit die having a transistor structure with a stack of semiconductor structures with doped ends and/or air gaps between the ends of the semiconductor structures, in accordance with some embodiments. The system may be a mobile computing platform 1805 and/or a data server machine 1806, for example. Either may employ a component assembly including an IC die having a transistor structure with a stack of semiconductor structures with doped ends and/or air gaps between the ends of the semiconductor structures as described elsewhere herein. Server machine 1806 may be any commercial server, for example including any number of high-performance computing platforms disposed within a rack and networked together for electronic data processing, which in the exemplary embodiment includes an IC die assembly 1850 with an IC die having a transistor structure with a stack of semiconductor structures with doped ends and/or air gaps between the ends of the semiconductor structures as described elsewhere herein. Mobile computing platform 1805 may be any portable device configured for each of electronic data display, electronic data processing, wireless electronic data transmission, or the like. For example, mobile computing platform 1805 may be any of a tablet, a smart phone, a laptop computer, etc., and may include a display screen (e.g., a capacitive, inductive, resistive, or optical touchscreen), a chip-level or package-level integrated system 1810, and a battery 1815. Although illustrated with respect to mobile computing platform 1805, in other examples, chip-level or package-level integrated system 1810 and a battery 1815 may be implemented in a desktop computing platform, an automotive computing platform, an internet of things platform, or the like. As discussed below, in some examples, the disclosed systems may include a sub-system 1860 such as a system on a chip (SOC) or an integrated system of multiple ICs, which is illustrated with respect to mobile computing platform 1805.

Whether disposed within integrated system 1810 illustrated in expanded view 1820 or as a stand-alone packaged device within data server machine 1806, sub-system 1860 may include memory circuitry and/or processor circuitry 1840 (e.g., RAM, a microprocessor, a multi-core microprocessor, graphics processor, etc.), a power management integrated circuit (PMIC) 1830, a controller 1835, and a radio frequency integrated circuit (RFIC) 1825 (e.g., including a wideband RF transmitter and/or receiver (TX/RX)). As shown, one or more IC dies, such as memory circuitry and/or processor circuitry 1840 may be assembled and implemented such that one or more have an IC die having a transistor structure with a stack of semiconductor structures with doped ends and/or air gaps between the ends of the semiconductor structures as described herein. In some embodiments, RFIC 1825 includes a digital baseband and an analog front end module further comprising a power amplifier on a transmit path and a low noise amplifier on a receive path). Functionally, PMIC 1830 may perform battery power regulation, DC-to-DC conversion, etc., and so has an input coupled to battery 1815, and an output providing a current supply to other functional modules. As further illustrated in FIG. 18, in the exemplary embodiment, RFIC 1825 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. Memory circuitry and/or processor circuitry 1840 may provide memory functionality for sub-system 1860, high level control, data processing and the like for sub-system 1860. In alternative implementations, each of the SOC modules may be integrated onto separate ICs coupled to a package substrate, interposer, or board.

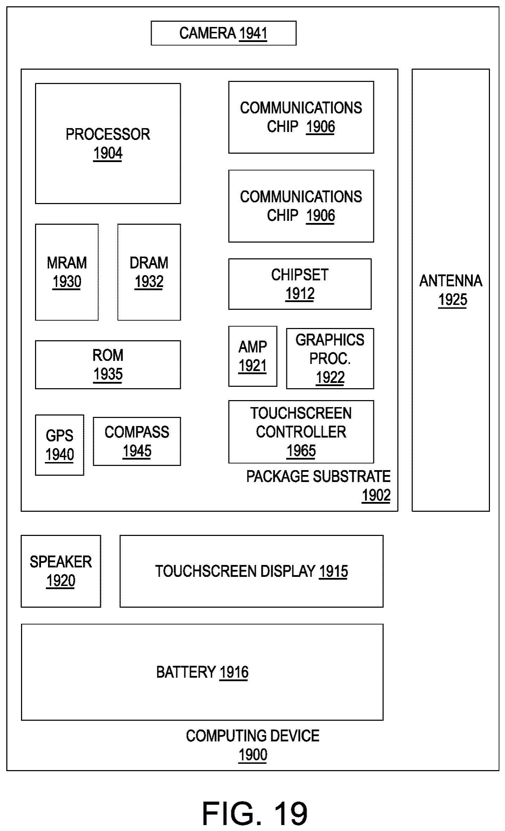

FIG. 19 is a functional block diagram of an electronic computing device 1900, in accordance with some embodiments. For example, device 1900 may, via any suitable component therein, having a transistor structure with a stack of semiconductor structures with doped ends and/or air gaps between the ends of the semiconductor structures in accordance with any embodiments described elsewhere herein. Device 1900 further includes a motherboard or package substrate 1902 hosting a number of components, such as, but not limited to, a processor 1904 (e.g., an applications processor). Processor 1904 may be physically and/or electrically coupled to package substrate 1902. In some examples, processor 1904 is within an IC assembly that includes an IC die having a transistor structure with a stack of semiconductor structures with doped ends and/or air gaps between the ends of the semiconductor structures as described elsewhere herein. In general, the term "processor" or "microprocessor" may refer to any device or portion of a device that processes electronic data from registers and/or memory to transform that electronic data into other electronic data that may be further stored in registers and/or memory.

In various examples, one or more communication chips 1906 may also be physically and/or electrically coupled to the package substrate 1902. In further implementations, communication chips 1906 may be part of processor 1904. Depending on its applications, computing device 1900 may include other components that may or may not be physically and electrically coupled to package substrate 1902. These other components include, but are not limited to, volatile memory (e.g., DRAM 1932), non-volatile memory (e.g., ROM 1935), flash memory (e.g., NAND or NOR), magnetic memory (MRAM 1930), a graphics processor 1922, a digital signal processor, a crypto processor, a chipset 1912, an antenna 1925, touchscreen display 1915, touchscreen controller 1965, battery 1916, audio codec, video codec, power amplifier 1921, global positioning system (GPS) device 1940, compass 1945, accelerometer, gyroscope, speaker 1920, camera 1941, and mass storage device (such as hard disk drive, solid-state drive (SSD), compact disk (CD), digital versatile disk (DVD), and so forth, or the like.

Communication chips 1906 may enable wireless communications for the transfer of data to and from the computing device 1900. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chips 1906 may implement any of a number of wireless standards or protocols, including, but not limited to, those described elsewhere herein. As discussed, computing device 1900 may include a plurality of communication chips 1906. For example, a first communication chip may be dedicated to shorter-range wireless communications, such as Wi-Fi and Bluetooth, and a second communication chip may be dedicated to longer-range wireless communications such as GPS, EDGE, GPRS, CDMA, WiMAX, LTE, Ev-DO, and others.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the invention is not limited to the embodiments so described, but can be practiced with modification and alteration without departing from the scope of the appended claims. For example the above embodiments may include specific combinations of features as further provided below.

The following pertains to exemplary embodiments.

In one or more first embodiments, an apparatus comprises a stack of semiconductor structures, a source structure epitaxial to a first end of each of the semiconductor structures and a drain structure epitaxial to a second end, laterally opposite the first end, of each of the semiconductor structures, a gate structure vertically between each of the semiconductor structures, and a gap laterally between the gate structure and one of the source structure and the drain structure.

In one or more second embodiments, further to the first embodiments, the first end and the second end of each of the semiconductor structures are doped with a dopant species at not less than a first dopant concentration and a center region of each of the semiconductor structures has a second dopant concentration of the dopant species of not more than 10% of the first dopant concentration.

In one or more third embodiments, further to the first or second embodiments, the first end of each of the semiconductor structures comprises a dopant concentration gradient that decreases monotonically from an edge of each of the first ends of the semiconductor structures toward the center region of each of the semiconductor structures.

In one or more fourth embodiments, further to the first through third embodiments, the gap is sealed between the gate structure, at least one of the semiconductor structures, at least one of the source structure or the drain structure, and a backside dielectric layer.

In one or more fifth embodiments, further to the first through fourth embodiments, the apparatus further comprises a backside contact laterally adjacent to the backside dielectric layer and in contact with one of the source structure or the drain structure.

In one or more sixth embodiments, further to the first through fifth embodiments, the apparatus further comprises a frontside contact in contact with another of the source structure or the drain structure.

In one or more seventh embodiments, further to the first through sixth embodiments, the apparatus further comprises a dielectric material between the gap and one of the gate structure or the source structure.

In one or more eighth embodiments, further to the first through seventh embodiments, the apparatus further comprises an integrated circuit (IC) die comprising the stack of semiconductor structures, the source structure, the drain structure, the gate structure, and the gap, and a power supply coupled to the IC die.

In one or more ninth embodiments, a system comprises an IC die according to any of the apparatuses of the first through seventh embodiments, and one of a power supply or a display coupled to the IC die.

In one or more tenth embodiments, an apparatus comprises a stack of semiconductor structures, a source structure epitaxial to a first end of each of the semiconductor structures and a drain structure epitaxial to a second end, opposite the first end, of each of the semiconductor structures, wherein the first end and the second end of each of the semiconductor structures are doped with a dopant species at not less than a first dopant concentration and a center region of each of the semiconductor structures has a second dopant concentration of the dopant species of not more than 10% of the first dopant concentration, and a gate structure vertically between each of the semiconductor structures.

In one or more eleventh embodiments, further to the tenth embodiments, the apparatus further comprises a dielectric material laterally between the gate structure and each of the source structure and the drain structure.

In one or more twelfth embodiments, further to the tenth or eleventh embodiments, the center region of each of the semiconductor structures is absent the dopant species.

In one or more thirteenth embodiments, further to the tenth through twelfth embodiments, the dopant species comprises one of boron, gallium, phosphorous, or arsenic.

In one or more fourteenth embodiments, further to the tenth through thirteenth embodiments, the first end of each of the semiconductor structures comprises a dopant concentration gradient that decreases monotonically from an edge of each of the first ends of the semiconductor structures toward the center region of each of the semiconductor structures.

In one or more fifteenth embodiments, further to the tenth through fourteenth embodiments, the apparatus further comprises a frontside contact coupled to one of the source structure or the drain structure, and a backside contact coupled to another of the source structure or the drain structure.

In one or more sixteenth embodiments, further to the tenth through fifteenth embodiments, the apparatus further comprises an integrated circuit (IC) die comprising the stack of semiconductor structures, the source structure, the drain structure, and the gate structure, and a power supply coupled to the IC die.

In one or more seventeenth embodiments, a system comprises an IC die according to any of the apparatuses of the tenth through fifteenth embodiments, and one of a power supply or a display coupled to the IC die.

In one or more eighteenth embodiments, a method comprises receiving a multilayer stack comprising a stack of semiconductor structures interleaved with a stack of sacrificial structures, epitaxially growing a source structure and a drain structure from opposing first and second ends of the multilayer stack, doping the first and second ends of the multilayer stack with a dopant species to form at least doped regions of the stack of sacrificial structures and an undoped region of the stack of sacrificial structures, removing the undoped region of the stack of sacrificial structures to at least partially expose the stack of semiconductor structures, forming a gate structure vertically between the stack of semiconductor structures and laterally adjacent the doped regions of the stack of sacrificial structures, and removing the doped regions of the stack of sacrificial structures to form an gap laterally between the gate structure and the source structure and the drain structure.

In one or more nineteenth embodiments, further to the eighteenth embodiments, removing the doped regions of the stack of sacrificial structures comprises a backside removal, and the method further comprises providing a dielectric layer adjacent to the gap to form a portion of a seal of the gap.

In one or more twentieth embodiments, further to the eighteenth or nineteenth embodiments, removing the doped regions of the stack of sacrificial structures comprises a backside removal, and the method further comprises filling the gap with a dielectric material.

In one or more twenty-first embodiments, further to the eighteenth through twentieth embodiments, the method further comprises forming a top side contact on one of the source structure and the drain structure, and forming a backside contact on the other of the source structure and the drain structure.

In one or more twenty-second embodiments, further to the eighteenth through twenty-first embodiments, doping the first and second ends of the multilayer stack comprises forming a dopant concentration gradient that decreases monotonically from an edge of the multilayer stack toward a center region of each of the multilayer stack.

It will be recognized that the invention is not limited to the embodiments so described, but can be practiced with modification and alteration without departing from the scope of the appended claims. For example, the above embodiments may include specific combination of features. However, the above embodiments are not limited in this regard and, in various implementations, the above embodiments may include the undertaking only a subset of such features, undertaking a different order of such features, undertaking a different combination of such features, and/or undertaking additional features than those features explicitly listed. The scope of the invention should, therefore, be determined with reference to the appended claims, along with the full scope of equivalents to which such claims are entitled.

## Claims

1. An apparatus, comprising:
a stack of semiconductor structures;
a source structure epitaxial to a first end of each of the semiconductor structures and a drain structure epitaxial to a second end, laterally opposite the first end, of each of the semiconductor structures;
a gate structure vertically between each of the semiconductor structures; and
a gap laterally between the gate structure and one of the source structure and the drain structure.

2. The apparatus of claim 1, wherein the first end and the second end of each of the semiconductor structures are doped with a dopant species at not less than a first dopant concentration and a center region of each of the semiconductor structures has a second dopant concentration of the dopant species of not more than 10% of the first dopant concentration.

3. The apparatus of claim 2, wherein the first end of each of the semiconductor structures comprises a dopant concentration gradient that decreases monotonically from an edge of each of the first ends of the semiconductor structures toward the center region of each of the semiconductor structures.

4. The apparatus of claim 2 or 3, wherein the center region of each of the semiconductor structures is absent the dopant species.

5. The apparatus of any one of claims 1 to 4, wherein the dopant species comprises one of boron, gallium, phosphorous, or arsenic.

6. The apparatus of any one of claims 1 to 5, wherein the gap is sealed between the gate structure, at least one of the semiconductor structures, at least one of the source structure or the drain structure, and a backside dielectric layer.

7. The apparatus of claim 6, further comprising a backside contact laterally adjacent to the backside dielectric layer and in contact with one of the source structure or the drain structure.

8. The apparatus of claim 7, further comprising a frontside contact in contact with another of the source structure or the drain structure.

9. The apparatus of any one of claims 1 to 8, further comprising a dielectric material between the gap and one of the gate structure or the source structure.

10. The apparatus of any one of claims 1 to 9, further comprising:
an integrated circuit (IC) die comprising the stack of semiconductor structures, the source structure, the drain structure, the gate structure, and the gap; and
a power supply coupled to the IC die.

11. A method, comprising:
receiving a multilayer stack comprising a stack of semiconductor structures interleaved with a stack of sacrificial structures;
epitaxially growing a source structure and a drain structure from opposing first and second ends of the multilayer stack;
doping the first and second ends of the multilayer stack with a dopant species to form at least doped regions of the stack of sacrificial structures and an undoped region of the stack of sacrificial structures;
removing the undoped region of the stack of sacrificial structures to at least partially expose the stack of semiconductor structures;
forming a gate structure vertically between the stack of semiconductor structures and laterally adjacent the doped regions of the stack of sacrificial structures; and
removing the doped regions of the stack of sacrificial structures to form a gap laterally between the gate structure and the source structure and the drain structure.

12. The method of claim 11, wherein removing the doped regions of the stack of sacrificial structures comprises a backside removal, the method further comprising:
providing a dielectric layer adjacent to the gap to form a portion of a seal of the gap.

13. The method of claim 11, wherein removing the doped regions of the stack of sacrificial structures comprises a backside removal, the method further comprising:
filling the gap with a dielectric material.

14. The method of any one of claims 11 to 13, further comprising:
forming a top side contact on one of the source structure and the drain structure; and
forming a backside contact on the other of the source structure and the drain structure.

15. The method of any one of claims 11 to 14, wherein doping the first and second ends of the multilayer stack comprises forming a dopant concentration gradient that decreases monotonically from an edge of the multilayer stack toward a center region of each of the multilayer stack.
